# EUROPEAN PATENT APPLICATION

(11) **EP 2 120 240 A1**
(43) Date of publication of application: **18.11.2009**
(21) Application number: 08425342.6
(22) Date of filing: 15.05.2008
(51) Int. Cl.: G11C 11/412

(54) **A static random access memory cell hardened to ionizing radiation**

(71) Applicant: UNIVERSITA' DEGLI STUDI DI MILANO, 20122 Milano (IT); RedCat Devices S.r.l., 20142 Milano (IT)
(72) Inventor: Calligaro, Cristiano, 27020 Torre D'Isola (Pavia) (IT); Liberali, Valentino, 27058 Voghera (Pavia) (IT); Stabile, Alberto, 26010 Izano (Cremona) (IT)
(74) Representative: Deambrogi, Edgardo

(57) **Abstract**

A static random access memory cell is described (300), consisting of a bistable circuit adapted to store a bit value, including a first logic inverter (301) and a second logic inverter (302) connected together in cascade, wherein the input of the first inverter (301) is connected to the output of the second inverter (302) at a first read/write node (QN) adapted to assume a bit value for the cell, and the input of the second inverter (302) is connected to the output of the first inverter (301) at a second read/write node (Q) adapted to assume a bit value for a cell having a logic state opposite in value to the bit assumed by the first node.
The cell comprises electrical charge (C) storing means arranged between the first and second read/write nodes (QN;Q) within the bistable circuit feedback loop.
According to an embodiment the charge storing means is a capacitor having interdigitated fingers. Preferably, the NMOS transistors of the inverters are made as ring-shaped edgeless transistors.

## Description

The present invention generally concerns semiconductor memory devices, and more specifically, an ionizing radiation-hardened static random access memory cell.

It is well known that ionizing radiation can cause malfunctions in integrated circuits that are exposed to it, and in particular, can cause switching of the state of a static RAM cell, with consequent loss of the data stored in said cell.

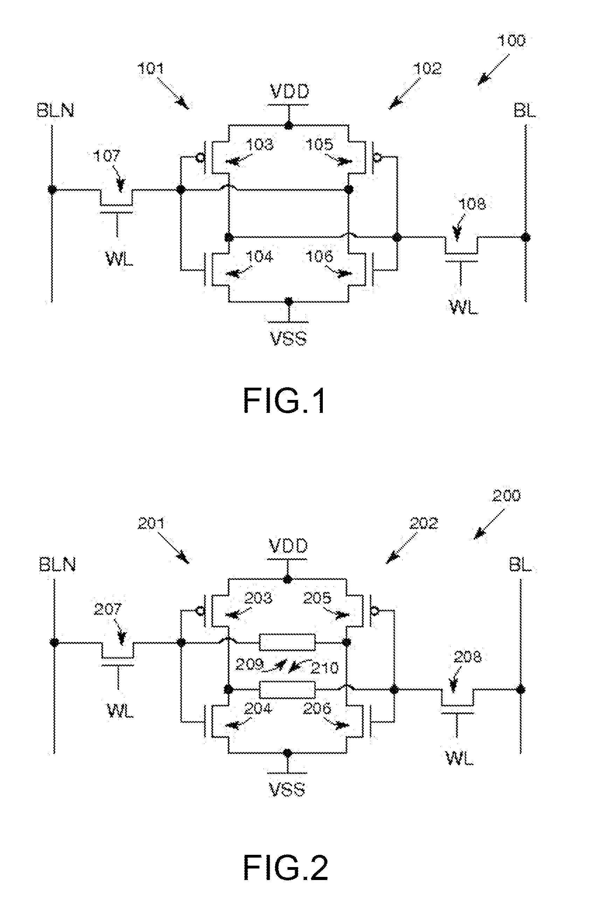

A static random access memory (SRAM) cell in the traditional six transistor MOS architecture is shown in figure 1, and indicated overall by 100. The cell comprises a bistable circuit including a first logic inverter 101 and a second logic inverter 102 connected together in cascade. In the detailed view of the circuit architecture, the first inverter 101 is achieved by means of a circuit arrangement including a first p-channel MOSFET 103 and a second n-channel MOSFET 104, and the second inverter 102 is achieved by means of a circuit arrangement including a first p-channel MOSFET 105 and a second n-channel MOSFET 106. The source terminals of MOSFETs 104 and 106 are connected to a reference potential, for example a voltage VSS, and the source terminals of MOSFETs 103 and 105 are connected to a supply voltage VDD. Coupling between the two logic inverters 101 and 102 is achieved by connecting the gate terminals of MOSFETs 103 and 104 to the drain terminals of MOSFETs 105 and 106, and the gate terminals of MOSFETs 105 and 106 to the drain terminals of MOSFETs 103 and 104.

A first cell transmission gate 107, also known as "pass gate", includes a MOSFET transistor with a first source (or drain) terminal connected to the drain terminals of MOSFETs 105 and 106, a second drain (or source) terminal connected to a first read/write line or bit line BLN and a gate terminal connected to a selection line or word line WL.

A second transmission gate 108 includes a MOSFET transistor with a first source (or drain) terminal connected to the drain terminals of MOSFETs 103 and 104, a second drain (or source) terminal connected to a second read/write line or bit line BL and a gate terminal connected to a selection line or word line WL.

Such SRAM cell may be vulnerable to collision with high-energy particles, such as protons or the ions of heavy elements, especially if used in circuits intended for aerospace and nuclear applications, and thus susceptible to exposure to ionising radiation, under typical operating conditions.

A high energy particle can cause an upset ("Single Event Upset, SEU") in the memory cell, resulting in variation of the state stored by the cell. In particular, the upset can occur when a high-energy particle deposits a charge in a point within the cell corresponding to one of its circuit nodes. The charge threshold at which such an upset can occur is identified as the memory cell critical charge. If the charge deposited as the result of the interaction with an external particle exceeds the critical charge, it can cause the switching of the original state of the cell node to the opposite state for a certain period of time. If the affected cell node is maintained in the switched state, opposite to that stored, for a period of time exceeding the cell feedback loop data propagation delay, the cell switches state and the data stored therein is lost.

There are various techniques and circuit architectures adapted to reduce the sensitivity of static RAM cells to the upsets caused by interaction with high energy particles.

The problem can be addressed by the adoption of redundancy techniques, both at the level of individual components, and the entire system. In this case, the solution consists of replication of the same circuits by a value of three or more, and in determination of the data correctly stored by the cell derived from the majority of the redundant circuits in the case where the data output from identical components differs, for example as a result of one of the components having been subject to upset.

Disadvantageously, such a solution with redundancy leads to an at least tripling of the components and the need to add additional combining components in order to achieve the "majority decision" function, with a necessary increase in architectural complexity.

An example of an SRAM memory cell with redundancy is the subject of US patent US 6,147,899.

A different solution known in the art is based on the addition of delay elements between the logic inverters of the cell bistable circuit, as shown in figure 2. Figure 2 depicts a memory cell 200 analogous to the cell indicated by 100 in figure 1, and identical elements or components have been indicated by similar numerical references. In the configuration proposed, two delay elements, indicated as 209 and 210 respectively, which may be made according to various technologies, for example as resistance elements or enhancement mode n or p-channel MOS transistors, and optionally include additional diodes are interposed along the connections between inverters 201 and 202.

The addition of said delay elements allows an increased propagation time for a bit forcing signal, for example a cell memory state upset signal, along the feedback path between the inverters, practically increasing the cell memory state keeping time in order to allow the dissipation of any charge deposited as a result of collision with high-energy particles. Disadvantageously however, the addition of said delay elements leads to a necessary increase in times required for memory read and write operations, as well as increased circuit area for the creation of said elements in an integrated technology.

An example of an SRAM memory cell with delay elements is the subject of US patent application US 2007 242,537.

The object of the present invention is to provide a static random access memory cell that is intrinsically hardened to ionising radiation, and specifically, a memory cell adapted to cancel the effects of the absorption of radiation or high energy particles for the purposes of preventing write errors or malfunctions due to individual interactions with free particles, and improve long-term memory reliability with regard to the total amount of absorbed radiation.

According to the present invention, this object is achieved thanks to a memory cell having the characteristics claimed in claim 1.

Particular embodiments form the subject of dependent claims, to be considered as an integral and integrating part of the present description.

In summary, the present invention is based on the principle of manufacturing a static RAM cell according to a traditional six transistor MOS architecture including an additional capacitor in the bistable circuit feedback loop, essentially in parallel with the logic inverters, and preferably based on the use of ring shaped edgeless n-channel MOS transistors.

The addition of a bistable circuit capacitor in the feedback loop has the effect of draining the electrical charge forming as a result of the interaction with high energy particles, thus slowing the switching of the state of the bit stored in the cell and also requiring greater charge to force said switching. The memory cell thus becomes slower and hence more tolerant to upsets generated by collisions with high energy particles (or, in equivalent terms, exposure to ionising radiation).

Advantageously, the capacitor may be made using planar technology through the deposition of plurality of metal layers over the MOS transistor formation area, thus bringing the additional advantage of constituting an additional screen against incident radiation, which loses a portion of its energy from crossing through the layers. This allows further to improve immunity against individual upset events.

Furthermore, replacing the traditional n-channel MOS transistors with ring-shaped edgeless transistors offers the advantage of making the transistors immune to the total amount of absorbed radiation. Indeed, the long-term effect caused by prolonged exposure to ionising radiation consists predominantly in the trapping of positive charges (holes), inducing the formation of a localised conductive path along the edges of the transistor. The ring shape results in the elimination of edges, consequently eliminating the problem.

Further characteristics and advantages of the invention will be described in greater detail in the following detailed description, provided purely by way of non-limiting example, with reference to the enclosed figures wherein:
figure 1 and figure 2 are circuit diagrams of an SRAM cell according to the prior art;
figure 3 is a circuit diagram of an SRAM cell with protection against ionising radiation according to the present invention;
figure 4 is a three-dimensional representation of a planar capacitor according to an interdigitated configuration; and
figure 5 is a plan view of the planar structure of a NMOSFET transistor with edgeless geometry.

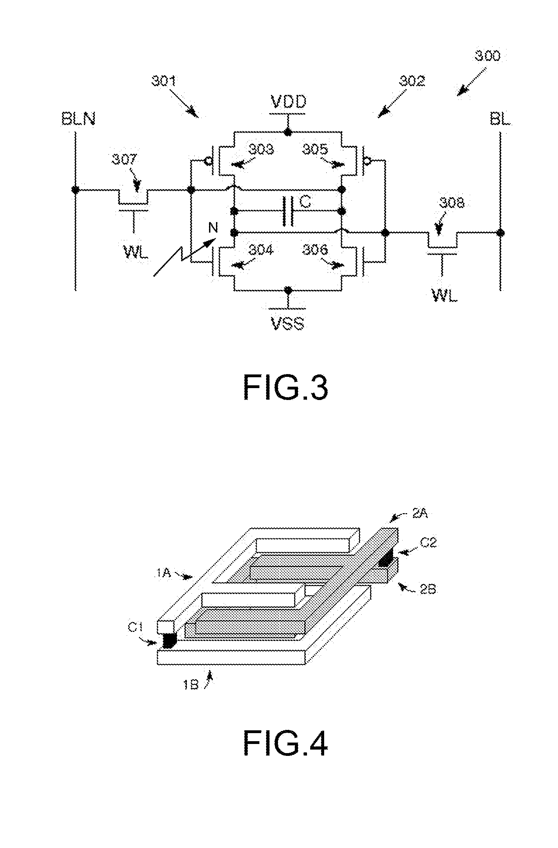

The general circuit diagram of an SRAM cell has been disclosed in the introductory section of this description with reference to figure 1. The circuit diagram of an SRAM cell hardened to ionising radiation according to the invention is shown in figure 3, wherein elements or components identical to or functionally equivalent to those shown in figure 1 have been indicated with similar reference numbers.

In figure 3, the static random access memory cell 300 comprises a bistable circuit including a first logic inverter 301 and a second logic inverter 302 coupled in cascade according to the traditional configuration, whereby the output of the second inverter 302 is connected directly to the input of the first inverter 301, and the output of the first inverter 301 is connected directly to the input of the second inverter 302.

In the detailed view of the circuit architecture, the first inverter 301 is achieved by means of a circuit arrangement including a first p-channel MOSFET 303 and a second n-channel MOSFET 304, and the second inverter 302 is achieved by means of a circuit arrangement including a first p-channel MOSFET 305 and a second n-channel MOSFET 306. The source terminals of MOSFETs 304 and 306 are connected to a reference potential, for example a voltage VSS, and the source terminals of MOSFETs 303 and 305 are connected to a supply voltage VDD. Coupling between the two logic inverters 301 and 302 is achieved by connecting the gate terminals of MOSFETs 303 and 304 to the drain terminals of MOSFETs 305 and 306, and the gate terminals of MOSFETs 305 and 306 to the drain terminals of MOSFETs 303 and 304.

A first transmission gate 307 connects a node QN at the input of the first inverter 301 and at the output of the second inverter 302 to an inverted read/write line or bit line BLN. A second transmission gate 308 connects a node Q at the input of the second inverter 302 and at the output of the first inverter 301, having logic state opposite to that of the logic state of node QN, to a non-inverted read/write line or bit line BL. A selection line or word line WL is coupled to the gate terminals of transmission gates 307 and 308.

A capacitor C is connected between node QN at the input of the first inverter 301 and node Q at the input of the second inverter 302, essentially in parallel with the inverters and in the feedback loop of the traditional bistable circuit.

The memory cell 300 operates as described below.

Under the undisturbed operating conditions, the cell 300 operates in read and write modes just like a traditional static memory cell, except for slowing down of the cell write operations, due to the insertion of the capacitor C.

Under an unperturbed static storage condition, the memory cell 300 registers, for example, a high logic value at node Q and a low logic value at node QN. Consequently, in the first inverter 301 the p-channel MOSFET 303 is in the ON-state while the n-channel MOSFET 304 is in the OFF-state. In the second inverter 302 the p-channel MOSFET 305 is in the OFF-state and the n-channel MOSFET 306 is in the ON-state.

When a high energy particle P interacts with the cell 300 an electrical charge is deposited on one node of the cell. Purely by way of example, a possible situation is shown in the figure, where a high energy particle P produces an electrical charge at a node N of the cell, near the drain terminal of the n-channel MOSFET 304, corresponding to the output node Q of the cell data storage bistable circuit. In this case, as a result of the electrical charge, the voltage at node N may be temporarily reduced.

If the drop in voltage at the node N is sufficiently large, it can have an influence on the logic state of the second inverter 302 and the output voltage at node QN may accordingly increase. If the rise time of the QN node is sufficiently short to cause switching of the n-channel MOSFET 304 to the ON-state and switching of the p-channel MOSFET 303 to the OFF-state before the end of the transient event due to the presence of the charge deposited by the particle P on node Q, then a write error on the memory cell can occur.

The capacitor C connected between nodes Q and QN is adapted to at least partially drain the electrical charge deposited by the particle P.

Specifically, the voltage drop at node Q is reduced and slowed down due to the effect of the parallel connection between the capacitor C and the capacitances associated with the gate terminals of the n-channel MOSFET 306 and the p-channel MOSFET 305. This particular condition occurs until such time as the n-channel 304 and p-channel 305 MOSFETs are in the OFF-state and the n-channel 306 and p-channel 303 MOSFETs are in the ON-state.

If the voltage drop at node Q is sufficiently large to influence the operational condition of the second inverter 302, then the output voltage at node QN can itself also vary, and in particular, increase. The capacitor C is connected between the input node Q and the output node QN of the second inverter 302 when the voltage at the input node Q is reduced and the voltage at the output node QN increases. In this case, the second inverter 302 acts as an inverting voltage amplifier with negative gain, and it will thus be understood that the capacitor C, by virtue of the fact that it is connected between the input and output of an inverting voltage amplifier, shows an amplified capacitance value according to the well-known Miller effect. Consequently, the voltage drop at node Q is reduced and slowed down even further thanks to the parallel connection between the capacitor C, with amplified capacitance due to the Miller effect, and the capacitances associated with the gate terminals of the n-channel MOSFET 306 and the p-channel MOSFET 305.

These particular operating conditions can give the cell sufficient time to drain the electrical charge deposited by the particle P before the voltage at node QN increases to a sufficiently high value, beyond the charge threshold, so as to cause an upset of the data stored in the cell. On the contrary, in a memory cell manufactured according to the traditional architecture, a similar case of exposure to ionising radiation would likely result in upset, even in the case of collisions with particles of lesser energy, and for shorter periods of time.

Naturally, similar situations can occur in the case where the cell 300 stores a high logic value at node Q and a low logic value at node QN, while a high energy particle interacts with the cell near the drain terminal of the p-channel MOSFET 305.

Analogously, other similar situations occur if the cell 300 stores a low logic value at node Q and a high logic value at node QN and the particle P interacts with the cell near the drain terminal of the n-channel MOSFET 306 or the drain terminal of the p-channel MOSFET 303.

As will be clear to those skilled in the art, in all these additional briefly-mentioned cases, the function of the memory cell forming the subject of the invention is analogous to that described in detail in the case presented by way of example, whereby it will not be described any further.

Conveniently, the capacitor C can be made according to particular deposition principles and in convenient shapes.

According to one preferred embodiment of the invention, an interdigitated plate geometry is convenient for reducing the overall deposition area and increasing the capacitance of the capacitor, as well as absorbing part of the energy from a colliding particle and reducing the linear transfer of energy from the particle to a sensitive node of the cell.

An interdigitated plate capacitor is formed from the deposition of one or more metallic layers, where the planar geometry in each of which maximises the lateral capacitance between the two terminals, facing the greatest possible number of elements of an interdigitated arrangement alternatingly connected to the first terminal and the second terminal of the capacitor. Due to the effect of the interdigitated geometry, applied to a plurality of metallic layers, wherein the positions of the terminals are switched between each pair of consecutive stacked layers, the capacitance/area ratio may be conveniently increased.

By way of example, figure 4 shows a configuration of a dual-level interdigitated capacitor wherein 1A and 2A indicate the capacitor plates connected to a first terminal C1 and to a second terminal C2 respectively, and lying in a first plane, and 1B and 2B indicate the capacitor plates connected to a first terminal C1 and to a second terminal C2 respectively, lying in a second plane.

The interdigitated plate capacitor constructed according to a multilayer configuration, if deposited over the memory cell MOSFETs, does not require the occupation of greater area of the device and brings the additional benefit of reducing the transfer of linear energy from a high energy particle colliding along the vertical direction of the IC chip, thus constituting a screen against incident radiation.

Further improvements may be made to the memory cell forming the subject of the invention shown and described with reference to figure 3, by controlling the planar manufacturing geometry of NMOSFET devices.

In particular, it is preferable to use ring-shaped edgeless NMOSFET transistors in order to increase the immunity of the same, and that of the overall memory cell, to the total amount of absorbed radiation.

In this regard, it is known the fact that radiation striking CMOS integrated circuits can lead to the creation of electron-hole pairs in the planar arrangement. If said pairs form in the oxide layer in proximity of a MOSFET transistor, the holes can remain trapped at the interface between the oxide and the semiconductor, and the density of trapped holes increases as the total amount of absorbed radiation increases. The effects resulting from trapped holes include variation of the MOSFET threshold voltage and the creation of parasitic channels along the edges of a NMOSFET transistor. In particular, this second effect results in the creation of parasitic transistors in parallel to the memory cell NMOSFET transistor, showing variable voltage-current characteristics over time depending on the amount of absorbed radiation. If the amount of absorbed radiation exceeds a threshold value over the operational lifespan of the device, the parasitic transistors may be permanently in the ON-state, giving rise to unwanted alternative conductive channels between the NMOSFET drain and source terminals.

In this particular embodiment, in order to eliminate the effects of parasitic transistors, it is convenient to use edgeless transistors, as recommended by G. M. Anelli in "*Conception et caractérisation des circuits intégrés résistants aux radiations pour le détecteur des particules du LHC en technologie CMOS submicronique profonde*", Ph.D. thesis, National Polytechnic Institute of Grenoble, France, December 2000.

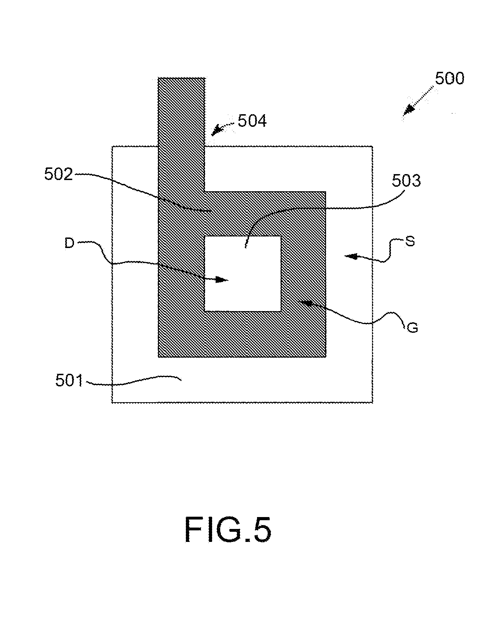

Figure 5 shows a possible geometry for a ring-shaped edgeless transistor. The NMOS transistor is indicated by 500 and shows a source region 501, a gate region 502 and a drain region 503. The drain region 503 is completely surrounded by the gate region 502, which is in turn almost completely surrounded by the source region 501, with the exception of a short section 504 where the gate region overlies the source region in order to extend beyond the same and form the gate contact terminal.

Since the edgeless NMOS transistor channel is formed by crossing the source region 501 below the gate region 502 until reaching the drain region 503, it will be clear that the channel has a closed geometry and does not extend outward to the source region 501. A parasitic component, activated due to the effect of an amount of radiation absorbed by the memory cell would be localised at the intersection between the gate region 502 and the edge 504 of the source region, connecting a part of the source region with another part of the same source region, thus avoiding short circuit effects.

For the above described reasons, in this particular embodiment of an ionising radiation hardened memory cell, it is preferable that all the NMOSFET transistors of the cell are designed with the ring-shaped edgeless geometry claimed herein.

Furthermore, since one of the most harmful effects caused by the impact of ionising radiation is represented by the well known "latch-up" phenomenon, which can lead to triggering of positive feedback with currents of such intensity as to irreversibly damage the integrated circuit, in this particular embodiment of an ionising radiation hardened memory cell, it is preferable that substrate and well biassing points be inserted inside individual cells, in order for them to screen the part of the circuit containing the p-channel MOSFET transistors and the part of the circuit containing the n-channel MOSFET transistors. The inclusion of substrate and well biassing points within the cell in order to separate the part with the p-channel MOSFET transistors from that with the n-channel MOSFET transistors, known per se, has the disadvantage of occupying a greater area, but guarantees the advantage of greater protection against the "latch-up" effect due to ionising radiation.

Naturally, without prejudice to the principle of the invention, the forms of implementation and embodiment details may be extensively changed with respect to what is described and illustrated purely by way of non-limiting example, without despite this departing from the scope of protection of the present invention as defined by the appended claims.

## Claims

1. A static random access memory cell (300), comprising a bistable circuit adapted to store a bit value, including a first logic inverter (301) and a second logic inverter (302) connected together in cascade, wherein:
the input of the first inverter (301) is connected to the output of the second inverter (302) at a first read/write node (QN) that can be coupled with a first bit read/write line (BLN) through a corresponding transmission logic gate (307) and adapted to assume a bit value for the cell;
the input of the second inverter (302) is connected to the output of the first inverter (301) at a second read/write node (Q) that can be coupled to a second bit read/write line (BL) through a corresponding transmission logic gate (308) and adapted to assume a bit value for the cell having a logic state opposite to the bit value assumed by the first node; and
the transmission logic gates (307, 308) are controlled by a common selection line (WL),
**characterised in that** it comprises electrical charge (C) storing means arranged between said first and second read/write nodes (QN; Q) within the bistable circuit feedback loop.

2. The static random access memory cell (300) according to claim 1, wherein said first and second read/write nodes (QN; Q) are connected together through a capacitor (C), the first plate of which is coupled to the first node (QN) and the second plate of which is coupled to the second node (Q).

3. The static random access memory cell (300) according to claim 2, wherein said first and second read/write nodes (QN; Q) are connected together through a planar capacitor (C1, C2) with interdigitated plates (1A, 1B; 2A, 2B).

4. The static random access memory cell (300) according to claims 2 or 3, wherein said first and second read/write nodes (QN; Q) are connected together through a capacitor (C1, C2) made by the deposition of a plurality of plate layers (1A, 2A; 1B, 2B) over the formation area of the electronic devices (303-308) making up the memory cell (300), in such a way as to constitute a screen for ionising radiation.

5. The static random access memory cell (300) according to any of the preceding claims, wherein said first and second logic inverter (301, 302) include a CMOS circuit arrangement including a first p-channel MOS transistor (303; 305) and a second n-channel MOS transistor (304; 306) coupled together at the corresponding drain terminals and having a common gate terminal defining a read/write node for the cell (QN; Q), wherein the source terminal of the first MOS transistor (303; 305) is connected to a supply voltage (VDD) and the source terminal of the second MOS transistor (304; 306) is connected to a reference potential (VSS), **characterised in that** the n-channel MOS transistors (304, 306) are made as ring-shaped edgeless transistors.
